Europäisches Patentamt

European Patent Office

Office européen des brevets

(19)

(11) Veröffentlichungsnummer: **0 049 794**

**A2**

## (12) EUROPÄISCHE PATENTANMELDUNG

(21) Anmeldenummer: **81107667.8**

(22) Anmeldetag: **26.09.81**

(51) Int. Cl.³: **H 03 K 17/945**
**G 08 B 13/00**

(30) Priorität: **09.10.80 DE 3038141**

(43) Veröffentlichungstag der Anmeldung:
**21.04.82 Patentblatt 82/16**

(84) Benannte Vertragsstaaten:
**AT BE CH FR GB IT LI LU NL SE**

(71) Anmelder: **Buck, Robert**
**Am Kirchbühl 28**
**D-7995 Neukirch(DE)**

(71) Anmelder: **Marhofer, Gerd**
**Beckmannsbusch 67**
**D-4300 Essen-Bredeney(DE)**

(72) Erfinder: **Buck, Robert**
**Am Kirchbühl 28**
**D-7995 Neukirch(DE)**

(72) Erfinder: **Marhofer, Gerd**
**Beckmannsbusch 67**
**D-4300 Essen-Bredeney(DE)**

(74) Vertreter: **Gesthuysen, Hans Dieter, Dipl.-Ing.**
**Huyssenallee 15**
**D-4300 Essen 1(DE)**

(54) Elektronisches, berührungslos arbeitendes Schaltgerät.

(57) Dargestellt und beschrieben ist ein elektronisches, berührungslos arbeitendes Schaltgerät (1), mit einem von außen beeinflußbaren Anwesenheitsindikator (2) und einem von dem Anwesenheitsindikator (2) steuerbaren elektronischen Schalter (3), z. B. einem Transistor, einem Thyristor oder einem Triac, wobei der Anwesenheitsindikator (2) für bestimmte Anwesenheitsimpulse sensitiv ist und dann den Schaltzustand des elektronischen Schalters (3) umsteuert, wenn von dem Anwesenheitsindikator (2) Anwesenheitsimpulse der Art, für die der Anwesenheitsindikator (2) sensitiv ist, mit einer oberhalb einer vorgegebenen Ansprechschwelle liegenden Ampulsamplitude und/oder -dauer empfangen worden sind.

Um eine noch weitergehende Störimpulssicherheit zu erreichen, wird nur dann der elektronische Schalter (3) von dem Anwesenheitsindikator (2) umgesteuert, wenn der Anwesenheitsindikator (2) eine vorgegebene Folge von Anwesenheitsimpulsen empfangen hat.

EP 0 049 794 A2

-/-

Die Erfindung betrifft ein elektronisches, berührungslos arbeitendes Schaltgerät, mit einem von außen beeinflußbaren Anwesenheitsindikator und einem
von dem Anwesenheitsindikator steuerbaren elektronischen Schalter, z. B.
einem Transistor, einem Thyristor oder einem Triac, wobei der Anwesenheitsindikator für bestimmte Anwesenheitsimpulse sensitiv ist und dann den
Schaltzustand des elektronischen Schalters umsteuert, wenn von dem Anwesenheitsindikator Anwesenheitsimpulse der Art, für die der Anwesenheitsindikator sensitiv ist, mit einer oberhalb einer vorgegebenen Ansprechschwelle liegenden Impulsamplitude und/oder -dauer empfangen worden sind.

Elektronische Schaltgeräte, die also kontaktlos ausgeführt sind, werden in
zunehmendem Maße anstelle von elektrischen, mechanisch betätigten Schaltgeräten, die konktaktbehaftet ausgeführt sind, in elektrischen Meß-, Steuer- und Regelkreisen verwendet. Dies gilt insbesondere für sogenannte Annäherungsschalter und für im folgenden sogenannte Anwesenheitsschalter,
d. h. für elektronische Schaltgeräte, die berührungslos arbeiten. Mit Annäherungsschaltern wird indiziert, ob sich ein - aktives oder passives -
Beeinflussungselement, für das der entsprechende Annäherungsschalter sensitiv ist, dem Annäherungsschalter hinreichend weit genähert hat. (Hat
sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter
um, - da. h. bei einem als Schließer ausgeführten Schaltgerät wird der
nicht leitende elektronische Schalter nunmehr leitend, während bei einem
als Öffner ausgeführten Schaltgerät der leitende elektronische Schalter
nunmehr sperrt.) Mit Anwesenheitsschaltern wird indiziert, ob sich ein
- aktives oder passives - Beeinflussungselement, für das der entsprechende Anwesenheitsschalter sensitiv ist, im Überwachungsbereich des Anwesenheitsschalters befindet und den Anwesenheitsindikator - hinreichend - beeinflußt. (Befindet sich im Überwachungsbereich des Anwesenheitsschalters
ein Beeinflussungselement, für das der entsprechende Anwesenheitsschalter sensitiv ist, und beeinflußt dieses Beeinflussungselement den Anwesenheitsindikator hinreichend, so steuert der Anwesenheitsindikator den elektronischen Schalter um, - wie dies zuvor in bezug auf Annäherungsschalter
erläutert worden ist.) Man kann den Ausdruck Anwesenheitsschalter auch
für Annäherungsschalter verwenden, wenn man den Ausdruck Anwesenheitsschalter in der zuvor erläuterten Weise versteht. Hat sich nämlich ein Beeinflussungselement, für das ein Annäherungsschalter sensitiv ist, dem Annäherungsschalter hinreichend weit genähert, so gilt auch, daß dann dieses
Beeinflussungselement sich im Überwachungsbereich des Annäherungsschalters
= Anwesenheitsschalters befindet und den Anwesenheitsindikator hinreichend
beeinflußt. Folglich soll im folgenden stets der Ausdruck Anwesenheitsschalter verwendet werden, weil dieser Ausdruck allgemeiner ist als der
gebräuchlichere Ausdruck Annäherungsschalter.

Wesentlicher Bestandteil von elektronsichen Schaltgeräten der eingangs
und zuvor beschriebenen Art ist also u. a. der von außen beeinflußbare
Anwesenheitsindikator. Als Anwesenheitsindikator kann z. B. ein Schallempfänger vorgesehen sein. Insbesondere kann als Anwesenheitsindikator
auch ein Lichtempfänger, z. B. ein Fotowiderstand, eine Fotodiode oder
ein Fototransistor, vorgesehen sein; es handelt sich dann um optpelektronische Anwesenheitsschalter.

(Optoelektronische Anwesenheitsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der
Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl
zum Lichtempfänger zurück reflektiert. In beiden Fällen spricht der An-

- 3 -

wesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei der der vom
Lichtsender kommende Lichtstrahl nur durch ein entsprechendes Beeinflussungselement zum Lichtempfänger zurück reflektiert wird.)

Im folgenden werden als Beispiel immer optoelektronische Anwesenheitsschalter behandelt. Gleichwohl gelten alle Ausführungen jedoch immer auch
für andere Arten von elektronischen Schaltgeräten der eingangs beschriebenen und zuvor erläuterten Art.

Bei elektronischen Schaltgeräten der in Rede stehenden Art, also bei solchen, bei denen der Anwesenheitsindikator - nur - für bestimmte Anwesenheitsimpulse sensitiv ist, muß dafür gesorgt werden, daß der elektronische
Schalter nicht durch den Anwesenheitsimpulsen, für die der Anwesenheitsindikator sensitiv ist, entsprechende Störimpulse umgesteuert wird; elektronische Schaltgeräte der in Rede stehenden Art müssen also störimpulssicher sein.

Im Stand der Technik, von dem die Erfindung ausgeht, hat man die zuvor
erläuterte notwendige Störimpulssicherheit schon mit verschiedenen Mitteln zu erreichen versucht. Insbesondere sind elektronische Schaltgeräte
der in Rede stehenden Art bekannt, bei denen zur Erzielung einer weitgehenden Störimpulssicherheit der Lichtempfänger nur dann sensitiv ist, wenn
der Lichtsender Lichtimpulse - als Anwesenheitsimpulse - abgibt. Auf den
Lichtempfänger auftreffende Lichtimpulse, auch solche der "richtigen" Impulsamplitude und/oder -dauer, werden also nur dann als Anwesenheitsimpulse verarbeitet, wenn sie genau dann auf den Lichtempfänger auftreffen,
wenn dieser sensitiv ist, wenn also der Lichtsender aktiv ist.

- 4 -

Der Erfindung liegt nun die Aufgabe zugrunde, ein Schaltgerät der eingangs beschriebenen und zuvor im einzelnen erläuterten Art anzugeben, das sich durch eine noch weitergehende Störimpulssicherheit auszeichnet.

Das erfindungsgemäße Schaltgerät, bei dem die zuvor aufgezeigte Aufgabe gelöst ist, ist zunächst und im wesentlichen dadurch gekennzeichnet, daß nur dann der elektronische Schalter von dem Anwesenheitsindikator umgesteuert wird, wenn der Anwesenheitsindikator eine vorgegebene Folge von Anwesenheitsimpulsen empfangen hat.

Bei den elektronischen, berührungslos arbeitenden Schaltgeräten, von denen die Erfindung ausgeht, führen den Anwesenheitsimpulsen, für die der Anwesenheitsindikator sensitiv ist, entsprechende Störimpulse gelegentlich zu einer fehlerhaften Umsteuerung des elektronischen Schalters. Das kann auch dann auftreten, wenn der Lichtempfänger nur dann sensitiv ist, wenn der Lichtsender aktiv ist. Es kann ja nicht ausgeschlossen werden, daß den Anwesenheitsimpulsen, für die der Anwesenheitsindikator sensitiv ist, entsprechende Störimpulse gerade dann auftreten, wenn der Lichtsender aktiv und folglich der Lichtempfänger sensitiv ist. Demgegenüber tritt bei dem erfindungsgemäßen Schaltgerät ein fehlerhaftes Umsteuern des elektronischen Schalters durch den Anwesenheitsimpulsen, für die der Anwesenheitsindikator sensitiv ist, entsprechende Störimpulse nur noch dann auf, wenn auf den Anwesenheitsindikator eine Folge von Störimpulsen trifft, die kongruent mit der vorgegebenen Folge von Anwesenheitsimpulsen ist. Das ist äußerst unwahrscheinlich, so daß sich das erfindungsgemäße elektronische Schaltgerät durch eine nochmals wesentlich erhöhte Störimpulssicherheit auszeichnet.

Im einzelnen gibt es verschiedene Möglichkeiten, die zuvor erläuterte Lehre der Erfindung zu realisieren sowie das erfindungsgemäße elektronische Schaltgerät auszugestalten und weiterzubilden, was im folgenden nur beispielhaft erläutert werden soll.

- 5 -

Eine optimale Störimpulssicherheit wird erreicht, wenn bei einem elektronischen Schaltgerät der in Rede stehenden Art, bei dem der Anwesenheitsindikator einen Anwesenheitsimpulssender und einen Anwesenheitsimpulsempfänger, z. B. einen Lichtsender und einen Lichtempfänger, aufweist, der Anwesenheitsimpulssender eine codierte Folge von Anwesenheitsimpulsen abgibt und nur dann der elektronische Schalter von dem Anwesenheitsindikator umgesteuert wird, wenn der Anwesenheitsimpulsempfänger die von dem Anwesenheitsimpulssender vorgegebene codierte Folge von Anwesenheitsimpulsen empfangen hat. Bei dieser Ausführungsform des erfindungsgemäßen elektronischen Schaltgerätes läßt sich mit an Sicherheit grenzender Wahrscheinlichkeit ausschließen, daß Störimpulse zu einem Umsteuern des elektronischen Schalters führen.

Die zuletzt beschriebene Ausführungsform des erfindungsgemäßen elektronischen Schaltgerätes, die sich durch eine optimale Störimpulssicherheit auszeichnet, läßt sich auch so ausführen, daß die codierte Folge von Anwesenheitsimpulsen, die der Anwesenheitsimpulssender abgibt, an dem Schaltgerät einstellbar ist. Dann kann man ansonsten gleiche Schaltgeräte unterschiedlich codieren, so daß die codierte Folge von Anwesenheitsimpulsen, die der Anwesenheitsimpulssender eines Schaltgerätes abgibt, nicht ein benachbartes Schaltgerät beeinflussen kann.

Die zuvor erläuterte Ausführungsform eines erfindungsgemäßen Schaltgerätes ist mit einem gewissen Aufwand verbunden, - als Preis für die erreichte optimale Störimpulssicherheit. Mit geringerem Aufwand läßt sich eine etwas reduzierte Störimpulssicherheit realisieren, die jedoch in der Regel völlig ausreichend ist. Eine solche Ausführungsform des erfindungsgemäßen Schaltgerätes ist dadurch gekennzeichnet, daß nur dann der elektronische Schalter von dem Anwesenheitsindikator umgesteuert wird, wenn der Anwesenheitsindikator eine vorgegebene Anzahl von Anwesenheitsimpulsen in ununterbrochener Reihenfolge empfangen hat. Das läßt sich z. B. da-

- 6 -

durch realisieren, daß dem Anwesenheitsindikator ein Integrator nachgeschaltet ist, der nur dann einen - den elektronischen Schalter umsteuernden - Steuerimpuls abgibt, wenn ihm eine vorgegebene Anzahl von Anwesenheitsimpulsen (oder von von den Anwesenheitsimpulsen abgeleiteten Eingangsimpulsen) zugeführt worden ist. Integrator ist dabei im weitesten
Sinne zu verstehen. Insbesondere kann der Integrator als analog arbeitendes, die einzelnen Anwesenheitsimpulse (oder von den Anwesenheitsimpulsen abgeleitete Eingangsimpulse) aufsummierendes Integrierglied oder als
digital arbeitendes, die einzelnen Anwesenheitsimpulse (oder von den Anwesenheitsimpulsen abgeleitete Eingangsimpulse) zählendes Zählglied ausgeführt sein. In jedem Fall kann die Ansprechschwelle des Integrators,
d. h. die Anzahl von Anwesenheitsimpulsen (bzw. von von den Anwesenheitsimpulsen abgeleiteten Eingangsimpulsen), bei der der Integrator einen
- den elektronischen Schalter umsteuernden - Steuerimpuls abgibt, einstellbar sein.

Im folgenden wird die Erfindung anhand eines Blockschaltbildes einer bevorzugten Ausführungsform des erfindungsgemäßen elektronischen Schaltgerätes erläutert.

Das als Blockschaltbild dargestellte elektronische Schaltgerät 1 arbeitet
berührungslos und besteht in seinem wesentlichen Aufbau aus einem Anwesenheitsindikator 2 und einem von dem Anwesenheitsindikator 2 steuerbaren
elektronischen Schalter 3, z. B. einem Transistor, einem Thyristor oder
einem Triac. Der Anwesenheitsindikator 2 ist für bestimmte Anwesenheitsimpulse sensitiv und steuert dann den Schaltzustand des elektronischen
Schalters 3 um, wenn von dem Anwesenheitsindikator 2 Anwesenheitsimpulse
der Art, für die der Anwesenheitsindikator 2 sensitiv ist, mit einer oberhalb einer vorgegebenen Ansprechschwelle liegenden Impulsamplitude und
-dauer empfangen worden sind. Das dargestellte elektronische Schaltgerät 1
ist ein optoelektronischer Anwesenheitsschalter (bzw. ein optoelektronischer Annäherungsschalter), so daß zu dem Anwesenheitsindikator 2 ein Lichtsender 4 und ein Lichtempfänger 5 gehören. Im dargestellten Ausführungsbeispiel ist zwischen dem Anwesenheitsindikator 2 und dem elektronischen Schalter 3 noch ein Schaltverstärker 6 vorgesehen.

Bei dem erfindungsgemäßen elektronischen Schaltgerät 1 wird nur dann der elektronische Schalter 3 von dem Anwesenheitsindikator 2 umgesteuert, wenn der Anwesenheitsindikator 2 eine vorgegebene Folge von Anwesenheitsimpulsen empfangen hat. Konkret wird bei dem dargestellten elektronischen Schaltgerät nur dann der elektronische Schalter 3 von dem Anwesenheitsindikator 2 umgesteuert, wenn der Anwesenheitsindikator 2 eine vorgegebene Anzahl von Anwesenheitsimpulsen in ununterbrochener Reihenfolge empfangen hat. Dazu ist dem Anwesenheitsindikator 2 ein Integrator 7 nachgeschaltet, der nur dann einen - den elektronischen Schalter 3 umsteuernden - Steuerimpuls abgibt, wenn ihm eine vorgegebene Anzahl von Anwesenheitsimpulsen (oder von von den Anwesenheitsimpulsen abgeleiteten Eingangsimpulsen) zugeführt worden ist. Der Integrator 7 kann als analog arbeitendes, die einzelnen Anwesenheitsimpulse aufsummierendes Integrierglied oder als digital arbeitendes, die einzelnen Anwesenheitsimpulse zählendes Zählglied ausgeführt sein. Vorzugsweise ist jedenfalls die Ansprechschwelle des Integrators 7, d. h. die Anzahl von Anwesenheitsimpulsen, bei der der Integrator 7 einen - den elektronischen Schalter 3 umsteuernden - Steuerimpuls abgibt, einstellbar.

- 9 -

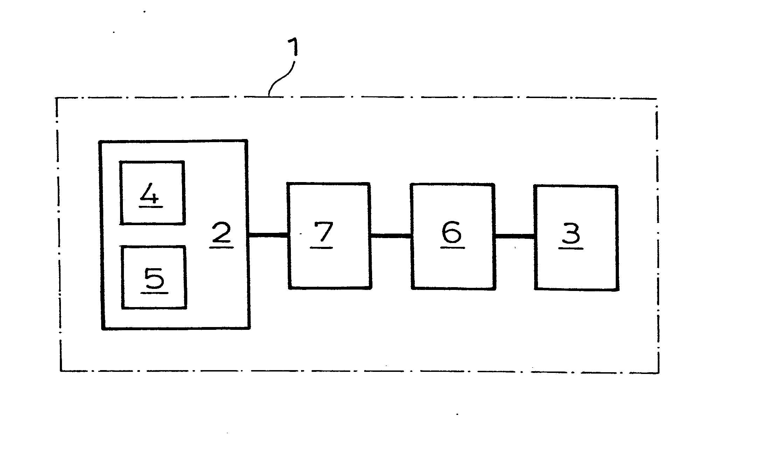

Patentansprüche:

1. Elektronisches, berührungslos arbeitendes Schaltgerät, mit einem von außen beeinflußbaren Anwesenheitsindikator und einem von dem Anwesenheitsindikator steuerbaren elektronischen Schalter, z. B. einem Transistor, einem Thyristor oder einem Triac, wobei der Anwesenheitsindikator für bestimmte Anwesenheitsimpulse sensitiv ist und dann den Schaltzustand des elektronischen Schalters umsteuert, wenn von dem Anwesenheitsindikator Anwesenheitsimpulse der Art, für die der Anwesenheitsindikator sensitiv ist, mit einer oberhalb einer vorgegebenen Ansprechschwelle liegenden Impulsamplitude und/oder -dauer empfangen worden sind, d a d u r c h   g e - k e n n z e i c h n e t, daß nur dann der elektronische Schalter (3) von dem Anwesenheitsindikator (2) umgesteuert wird, wenn der Anwesenheitsindikator (2) eine vorgegebene Folge von Anwesenheitsimpulsen empfangen hat.

2. Elektronisches Schaltgerät nach Anspruch 1, wobei der Anwesenheitsindikator einen Anwesenheitsimpulssender und einen Anwesenheitsimpulsempfänger aufweist, dadurch gekennzeichnet, daß der Anwesenheitsimpulssender eine codierte Folge von Anwesenheitsimpulsen abgibt und nur dann der elektronische Schalter von dem Anwesenheitsindikator umgesteuert wird, wenn der Anwesenheitsimpulsempfänger die von dem Anwesenheitsimpulssender vorgegebene codierte Folge von Anwesenheitsimpulsen empfangen hat.

3. Elektronisches Schaltgerät nach Anspruch 2, dadurch gekennzeichnet, daß die codierte Folge von Anwesenheitsimpulsen, die der Anwesenheitsimpulssender abgibt, einstellbar ist.

4. Elektronisches Schaltgerät nach Anspruch 1, dadurch gekennzeichnet, daß nur dann der elektronische Schalter (3) von dem Anwesenheitsindikator (2) umgesteuert wird, wenn der Anwesenheitsindikator (2) eine vorgegebene Anzahl von Anwesenheitsimpulsen in ununterbrochender Reihenfolge empfangen hat.

- 9 -

5. Elektronisches Schaltgerät nach Anspruch 4, dadurch gekennzeichnet, daß dem Anwesenheitsindikator (2) ein Integrator (7) nachgeschaltet ist, der nur dann einen - den elektronischen Schalter (3) umsteuernden - Steuerimpuls abgibt, wenn ihm eine vorgegebene Anzahl von Anwesenheitsimpulsen (oder von von den Anwesenheitsimpulsen abgeleiteten Eingangsimpulsen) zugeführt worden ist.

6. Elektronisches Schaltgerät nach Anspruch 5, dadurch gekennzeichnet, daß der Integrator (7) als analog arbeitendes, die einzelnen Anwesenheitsimpulse aufsummierendes Integrierglied ausgeführt ist.

7. Elektronisches Schaltgerät nach Anspruch 5, dadurch gekennzeichnet, daß der Integrator (7) als digital arbeitendes, die einzelnen Anwesenheitsimpulse zählendes Zählglied ausgeführt ist.

8. Elektronisches Schaltgerät nach einem der Ansprüche 5 bis 7, dadurch gekennzeichnet, daß die Ansprechschwelle des Integrators (7), d. h. die Anzahl von Anwesenheitsimpulsen, bei der der Integrator (7) einen - den elektronischen Schalter (3) umsteuernden - Steuerimpuls abgibt, einstellbar ist.